# EUROPEAN PATENT APPLICATION

(11) **EP 1 876 874 A1**
(43) Date of publication of application: **09.01.2008**
(21) Application number: 06715612.5
(22) Date of filing: 13.03.2006
(51) Int. Cl.: H05K 3/34, B23K 1/08

(54) **WAVE SOLDERING BATH**

(30) Priority: 06.04.2005 JP 2005109534
(71) Applicant: SENJU METAL INDUSTRY CO., LTD., Tokyo, 120-8555 (JP)
(72) Inventor: ZEN, Mitsuo, Souka-shi, Saitama 340-0035 (JP); OZAWA, Satoshi, Hanamigawa-ku, Chiba-shi, Chiba 262-0046 (JP)
(74) Representative: Texier, Christian
(86) International application number: PCT/JP2006/304889
(87) International publication number: WO 2006/112216

(57) **Abstract**

Problem: In a conventional wave soldering bath, oxides which intermixed with molten solder were sucked into a duct from a suction port of the duct and were discharged from a discharge nozzle and adhered to printed circuit boards.

Means for Solving the Problem: In a wave soldering bath according to the present invention, an oxide reservoir is provided at one end of the bath body which is opposite from the end thereof where a pump is installed, and a gutter which is closed off on the pump side is mounted on the side surface of the discharge nozzle. A perforated plate having a large number of holes formed therein is pivotably installed at a middle height of the oxide reservoir.

## Description

### Technical Field

This invention relates to a wave soldering bath which causes molten solder to spout so as to contact the spouted molten solder with printed circuit boards and adhere it to the printed circuit boards.

### Background Art

Soldering of printed circuit boards incorporated into household electrical appliances such as televisions and videos is generally carried out by the flow soldering method, which is suitable for mass production. Soldering by the flow soldering method is performed with an automatic soldering apparatus. An automatic soldering apparatus used in flow soldering includes processing units such as a fluxer, a preheater, a wave soldering bath, and a cooler. A transport conveyor is installed above these processing units. A printed circuit board is held by the transport conveyor, and while it is traveling above the processing units, soldering is carried out by applying flux to it by means of the fluxer, preheating it by means of the preheater, adhering solder to it in the wave soldering bath, cooling it by means of the cooler.

During soldering of a printed circuit board, soldering defects may develop if suitable processing is not carried out by each processing unit. In particular, in a wave soldering bath, problems sometimes occur due to oxides of solder (referred to below simply as oxides) adhering to a printed circuit board. If oxides adhere to a printed circuit board, not only does the appearance of the printed circuit board itself become poor and its value as a product decrease, but if oxides adhere between adjoining soldered portions, the oxides cause a decrease in insulating resistance and short circuits and completely impair the function of electronic appliances. Therefore, oxides must be prevented from adhering to printed circuit boards in a wave soldering bath.

The cause of adhesion of oxides to a printed circuit board when soldering of a printed circuit board is carried out in a wave soldering bath is that oxides are sucked into a discharge pump and discharged from a discharge nozzle together with molten solder and adhere to the printed circuit board. Explaining this in more detail, in a wave soldering bath, molten solder is always in a clean state when discharged from discharge nozzles, but at the time of discharge, molten solder combines with oxygen in air to form oxides. Oxides have a lower specific gravity than molten solder, so they float in the periphery of the discharge nozzle. If these oxides are simply floating in this manner, the oxides are not sucked into the discharge pump located below them. This is because a discharge pump is disposed in the lower portion of a wave soldering bath, and in many wave soldering baths, the suction port of a discharge pump faces downwards, so oxides having a low specific gravity do not sink down to the suction port. However, there are cases in which oxides floating on the surface of molten solder are sucked into a discharge pump disposed in the lower portion and are discharged from a discharge nozzle and adhere to a printed circuit board. This is because after molten solder is discharged from a discharge nozzle in a wave soldering bath, it falls into molten solder and sinks deep therein. At this time, oxides floating on the surface are entrained by the sinking molten solder and sink deep into molten solder. These oxides are sucked into the discharge pump together with molten solder and discharged from the discharge nozzle.

There have been many proposals of conventional wave soldering baths in which oxides are prevented from adhering to printed circuit boards. The wave soldering bath proposed by the present applicant in JP H07-42324 U1 (Patent Document 1) has a gutter installed on the side surface of a discharge nozzle, a reservoir formed on the opposite side from a discharge pump, and a partition formed from a mesh or a perforated plate which is installed between the reservoir and the bath body. In the wave soldering bath of Patent Document 1, molten solder discharged from the discharge nozzle does not fall into the molten solder in the bath body and is instead received by the gutter, so oxides do not sink into the molten solder. In addition, in this wave soldering bath, the discharged molten solder which is received in the gutter is adapted to flow into the reservoir, and a partition formed from a metal mesh, a perforated plate, or similar material is provided between the reservoir and the discharge pump, so oxides are filtered out by the partition.

Similarly, the wave soldering bath proposed by the present applicant in JP H06-23663 U1 (Patent Document 2) has a partition formed from a metal mesh, a perforated plate, or similar material which is disposed between a reservoir and a bath body, and a cage formed from a mesh or a perforated plate is disposed in the reservoir. In this wave soldering bath, oxides which collect in the reservoir are filtered out by the cage and the partition, and only molten solder passes therethrough. When oxides which are filtered out by the cage accumulate in the reservoir, the cage is removed from the wave soldering bath and the oxides are discarded.

JP S58-76375 U1 (Patent Document 3) discloses a wave soldering bath in which a plate-shaped partition having an upper portion which projects above the liquid surface of molten solder and a lower portion which allows fluid communication is provided in the bath body so as to separate the discharge nozzle and the discharge pump from each other. In the wave soldering bath of Patent Document 3, oxides which are formed in the periphery of the discharge nozzle float on the surface of molten solder and prevented from moving towards the discharge pump due to the partition.
Patent Document 1: JP H07-42324 U1
Patent Document 2: JP H06-23663 U1
Patent Document 3: JP S58-76375 U1

### Disclosure of Invention

In the wave soldering bath of Patent Document 1, namely, in a wave soldering bath having a gutter installed on the side surface of a discharge nozzle and a partition made of a metal mesh or a perforated plate disposed between a reservoir and the bath body, since the partition obstructs movement of oxides, oxides are not sucked into the discharge pump. However, in a wave soldering bath equipped with a partition, oxides adhere to the partition, and as they accumulate, they separate from the partition and end up being sucked into the discharge pump. Therefore, it was necessary to periodically remove oxides adhering to the partition. However, not only was the operation of removing oxides from the partition very troublesome, but it was not possible to completely remove oxides. Namely, in a wave soldering bath equipped with a partition, the partition is installed inside molten solder, and removal of oxides must be carried out gropingly. In the process of removing oxides, a long spatula is inserted into the molten solder from above its surface, and the partition is scraped with the spatula to scrape off oxides adhering to the surface of the partition. It is not possible to see inside the molten solder from above, so it is difficult to completely remove oxides. Furthermore, this operation is very dangerous in that during the removal operation, molten solder is splashed by the spatula and may contact the operator.

In Patent Document 2, a cage of a metal mesh or perforated plate is submerged in a reservoir, and after oxides floating atop the reservoir are filtered out by the cage, the cage is removed from the wave soldering bath, and oxides are discarded into a container for waste. At this time, in order to remove oxides adhering to the surface of the cage, the cage is struck against the container for disposal, or an impact is imparted to the cage, or the surface of the cage is scraped with a spatula to remove oxides. However, when the cage is taken out of the wave soldering bath, the cage and the oxides are cooled, and thus oxides adhering to the metal mesh or the perforated plate of the cage solidify and cannot be easily removed by impacts or scraping. In addition, oxides adhere to a partition in the wave soldering bath of Patent Document 2 in the same manner as in Patent Document 1, so the oxides must be periodically removed, and doing so is very troublesome and dangerous.

In the wave soldering bath of Patent Document 3, since a plate-shaped partition is provided at the surface of molten solder, oxides floating on the surface of the molten solder are intercepted by the partition and do not move in the direction of the discharge pump. However, in this wave soldering bath, molten solder which falls from the discharge nozzle after being spouted therefrom entrains oxides in the periphery of the discharge nozzle and causes the oxides to sink, and these oxides are sucked into the discharge pump. In addition, in this wave soldering bath, if a large amount of oxides accumulated on the surface of molten solder, the oxides sometimes overflowed from the wave soldering bath and spilled to the outside. If oxides spilled from the wave soldering bath, the problems occurred that the oxides scorched wiring of the automatic soldering apparatus or the floor of the workplace, and oxides which spilled and splattered contacted operators and caused burns.

If a partition such as a metal mesh or a perforated plate is installed between a reservoir and a bath body, oxides are in fact filtered out by the partition and do not move towards the discharge pump. However, oxides adhere to the partition, and removal thereof entails a great deal of effort and danger. The present inventors carried out diligent investigation concerning a means for preventing oxides from moving towards a discharge pump without installing a partition. As a result, they found that when molten solder falls from a discharge nozzle, if there is a cushioning member in molten solder where the fall takes place, the falling molten solder does not sink below the cushioning member, and as a result, even if oxides are intermixed with the falling molten solder, the oxides do not sink downwards and are not sucked into the discharge pump. As a result, they completed the present invention.

The present invention is a wave soldering bath comprising a bath body having a discharge nozzle and a discharge pump installed therein, characterized in that an oxide reservoir is provided at one end of the bath body which is opposite from the end thereof where the discharge pump is installed, a gutter which is closed off at its end on the pump side is installed on the side surface of the discharge nozzle, a perforated plate is installed in the oxide reservoir located at the exit of the gutter so as to be submerged below the liquid surface, one end of the perforated plate being pivotably installed on the discharge nozzle or the bath body, and a lever which projects above the liquid surface is installed on the other end of the perforated plate.

A wave soldering bath according to the present invention has a gutter installed along the side of a discharge nozzle, and molten solder which has been discharged from the discharge nozzle falls into the gutter and does not directly fall into molten solder in the periphery of the discharge nozzle. As a result, oxides formed by oxidation of the molten solder during discharge do not float in the periphery of the discharge nozzle. Accordingly, in a wave soldering bath according to the present invention, even if molten solder is discharged from the discharge nozzle and falls with much energy, it falls into the gutter. As a result, there is no occurrence of a situation in which oxides are present in the periphery of the discharge nozzle and they are made to sink deeply towards the bottom, so of course they are not sucked into a pump installed in the lower portion.

In addition, in a wave soldering bath according to the present invention, since the pump side end of a gutter installed on the side surface of a discharge nozzle is closed off, all discharged molten solder which is intermixed with oxides flows into the oxide reservoir which is situated away from the position in which the pump is installed, and even if oxides sink deep into the oxide reservoir, they are not sucked into the pump. If the gutter is sloped downwards towards the oxide reservoir, oxides flow into the oxide reservoir without accumulating inside the gutter.

In a wave soldering bath according to the present invention, since a perforated plate is installed in an oxide reservoir so as to submerge in molten solder, molten solder having oxides mixed therein which flows from the gutter into the oxide reservoir has its inflowing energy dampened by the perforated plate, and the molten solder loses its energy. As a result, oxides do not sink below the perforated plate and are not sucked into the pump.

The perforated plate in the wave soldering bath according to the present invention is pivotably secured on the bath body or the discharge nozzle. Even if oxides adhere to the perforated plate, by simply moving the perforated plate up and down in the molten solder, oxides adhering to the perforated plate can be easily removed from the perforated plate. Because the removed oxides float atop the molten solder, they can be removed by picking up them together. In this manner, in a wave soldering bath according to the present invention, not only can the process of removing oxides adhered to a perforated plate be simply carried out, but there is no danger of splashing of molten solder.

### Brief Explanation of the Drawings

Figure 1 is a cut-away perspective view of a wave soldering bath according to the present invention.
Figure 2 is a front cross-sectional view of the bath taken through a portion of the gutter of a second discharge nozzle.
Figure 3 is a side cross-sectional view of the bath taken through a portion of an oxide reservoir.
Figure 4 is an explanatory side cross-sectional view of the bath showing the flow of oxides.

List of reference numerals:
1 wave soldering bath; 2 bath body; 3 first discharge nozzle; 4 second discharge nozzle; 5 molten solder; 18, 19, 20 gutter; 21 exit of gutter;
22 perforated plate; 26 lever

### Best Mode for Carrying Out the Invention

The position for installing a perforated plate in a wave soldering bath according to the present invention, namely, the installation position below the surface of molten solder is suitably 10 - 200 mm. If the installation position of the perforated plate is shallower than 10 mm below the surface of the molten solder, molten solder which falls from the gutter rebounds from the perforated plate and ends up forming oxides, and molten solder having energy due to falling from the gutter passes through the holes in the perforated plate in an energized state and sinks downward together with oxides and ends up being sucked into the discharge pump. On the other hand, if the installation position of the perforated plate is deeper than 200 mm below the surface of molten solder, molten solder which falls from the gutter moves towards the discharge pump before reaching the perforated plate, and oxides are sucked into the discharge pump.

The diameter of holes in the perforated plate installed in a wave soldering bath according to the present invention is 2 - 10 mm. If the hole diameter of the perforated plate is smaller than 2 mm, it becomes easy for oxides to adhere to the holes and soon causes the holes to clog up. If the hole diameter is larger than 10 mm, molten solder which flows downwards from the gutter with much energy passes through the holes in an energized state and sinks deeply, and oxides also sink deeply and end up being sucked into the discharge pump.

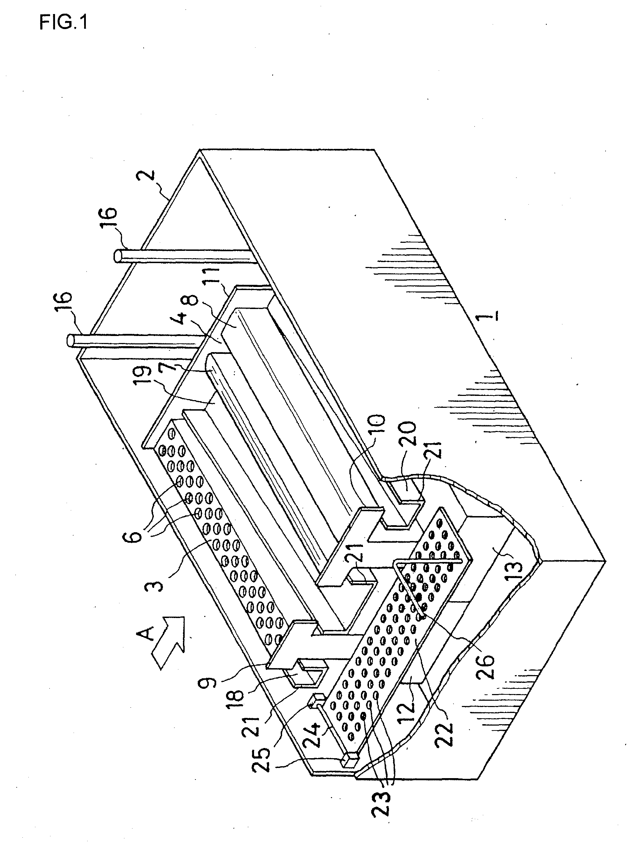

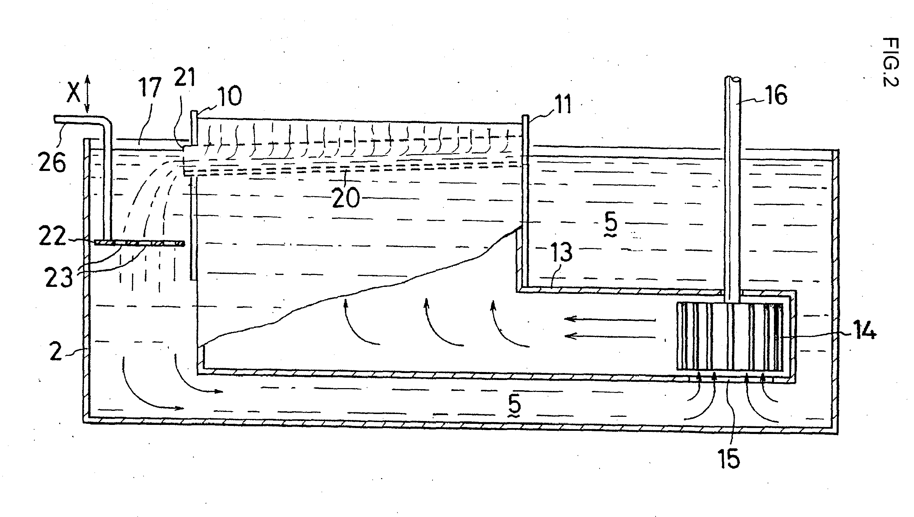

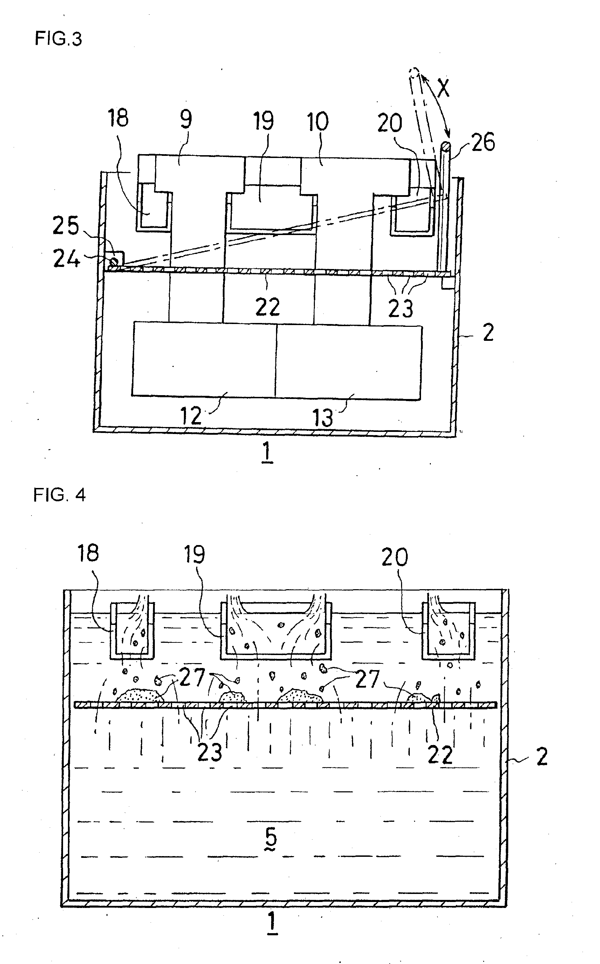

Below, a wave soldering bath according to the present invention will be explained based on the drawings. Figure 1 is a cut-away perspective view of a wave soldering bath of the present invention, Figure 2 is a front cross-sectional view thereof taken through a portion of a gutter for a second discharge nozzle, Figure 3 is a side cross-sectional view thereof taken through a portion of an oxide reservoir, and Figure 4 is a side cross-sectional view thereof for explaining the flow of oxides.

A wave soldering bath 1 comprises a bath body 2 in the shape of a lidless box. Inside the bath body, a first discharge nozzle 3 and a second discharge nozzle 4 (the first discharge nozzle and the second discharge nozzle may also be collectively referred to simply as the discharge nozzles) are successively arranged in the direction of advance (the direction of arrow A) of an unillustrated printed circuit board. Molten solder 5 is disposed inside the bath body. The molten solder 5 contained inside the bath body is maintained in a molten state and at a predetermined temperature by an unillustrated electric heater. A large number of discharge holes 6 are formed in the upper portion of the first discharge nozzle 3. These holes are for the purpose of making the spouting molten solder turbulent and making molten solder penetrate into through holes of the printed circuit board and crevices of electronic parts. Molten solder which spouts from the first discharge nozzle is in a turbulent state with surface irregularities, so it causes defects such as icicles and bridges in soldered portions. These defects are removed by molten solder which is gently spouted from the second discharge nozzle. The second discharge nozzle 4 has a wide discharge port. Secured to the discharge port are a front plate 7 which is curved towards the entrance side from which a printed circuit board enters, and a wide, flat rear plate 8 which is situated at the exit side from which a printed circuit board exits, so molten solder which flows from the discharge port is made gentle, and icicles and bridges which developed during soldering by the first discharge nozzle are removed. Side plates 9, 10, and 11 are installed on both sides of the first discharge nozzle 3 and the second discharge nozzle 4 to prevent molten solder discharged from the discharge nozzles from flowing sideways.

The first discharge nozzle 3 and the second discharge nozzle 4 are installed on the upper portions of ducts 12 and 13, respectively. A discharge pump 14 is installed at one end portion of each of the ducts 12 and 13, and a suction port 15 is formed in the duct 13 below the discharge pump. A shaft 16 is secured at the center of the upper portion of each discharge pump 14. Each shaft passes through the ceiling of duct 12 or 13, and its upper portion projects above the surface of molten solder 5. An unillustrated pulley is installed on the upper end of each shaft 16, and the pulley is drivingly connected to an unillustrated motor. The end of the bath body 2 opposite from the side where the discharge pump 14 is installed forms an oxide reservoir 17.

Gutters 18 and 19 are installed on both sides of the first discharge nozzle 3, and gutters 19 and 20 are installed on both sides of the second discharge nozzle 4. Gutter 19 is used in common by both the first discharge nozzle 3 and the second discharge nozzle 4. These gutters are sloped downwards towards the oxide reservoir 17, and the end portions at the upper end of the slope are closed off by the side plate 11. The exits 21 of these gutters 18, 19, and 20 are located at the oxide reservoir 17.

A perforated plate 22 is pivotably installed in the molten solder in the oxide reservoir 17 in a location lower than the exits 21 of the gutters 18, 19, and 20. A large number of holes 23 are formed in the perforated plate. The perforated plate 22 is installed such that one of its ends is secured to a rod 24, and the rod is pivotably mounted on holders 25, 25 secured to an inner side wall of the bath body 2. A lever 26 extends upwards from the other end of the perforated plate 22. The upper portion of the lever 26 where it is higher than the bath body 2 is bent towards the exterior of the bath body 2, and if the lever 26 is lifted in the direction of arrow X, the perforated plate 22 can be pivoted as shown by the dashed line in Figure 3.

Next, the discharge of molten solder in a wave soldering bath according to the present invention having the above-described structure will be explained. When unillustrated motors are driven, the shafts 16 connected to the motors rotate, and the discharge pumps 14 secured to the shafts rotate. Discharge pump 14 sucks molten solder 5 located below duct 13 into the duct through the suction port 15 of duct 13 and sends it to the rear portion of the duct as shown by the arrows in Figure 2. The molten solder which is sent to the rear portion of duct 13 changes its direction of flow upwards, and it is spouted from the discharge nozzles 3 and 4 installed in the upper portion of duct 13. Although not shown in the drawings, at this time, molten solder is discharged from the large number of discharge holes 6 in the first discharge nozzle 3, so it is discharged in a turbulent state with surface irregularities, while in the second discharge nozzle, it is discharged from the wide discharge port, so it is smoothly discharged. The molten solder which is discharged from the discharge nozzles contacts air and forms oxides, which are mixed into the molten solder after discharge.

Due to the gutters 18, 19, and 20 installed on the side surfaces of the discharge nozzles, molten solder which is spouted from the discharge nozzles falls into these gutters and flows down on the slope of the gutters into the oxide reservoir 17. Molten solder having oxides mixed therein which flows into the oxide reservoir 17 sinks into the molten solder in the oxide reservoir due to the energy of inflow from the gutters 18, 19, and 20. However, since the perforated plate 22 is installed at a middle height of the oxide reservoir 17, the molten solder sinking downwards has its energy dampened by the perforated plate and loses its energy. As a result, the energy causing the molten solder to sink is dissipated, and the oxides which are mixed into the molten solder and which have a relatively low specific gravity float upwards. Accordingly, oxides in the molten solder which flows from the gutters into the oxide reservoir float upwards, and only molten solder passes through the large number of holes 23 in the perforated plate 22 and flows below the ducts and is sucked into the ducts from the suction ports 15 of the ducts. At this time, the perforated plate serves to dampen the energy of the downwardly sinking molten solder and also to filter out oxides. Oxides are not mixed into the molten solder which is sucked into duct 13, and oxides are of course not intermixed with the molten solder which is discharged from the discharge nozzles, so oxides do not adhere to printed circuit boards which are soldered by contact with the spouting molten solder.

In this manner, molten solder having oxides mixed therein has its energy dampened by the perforated plate 22, and oxides are filtered out by the large number of holes 23 in the perforated plate 22. Therefore, while the wave soldering bath is operated for a long period, oxides 27 adhere to the perforated plate 22 and accumulate as shown in Figure 4. If a large amount of oxides accumulate on the perforated plate 22, the holes 23 in the perforated plate become blocked, and not only is the passage of molten solder prevented, but oxides flow below the duct 13 together with molten solder and end up being sucked into the duct through the suction port 15.

Therefore, in this wave soldering bath, oxides adhering to the perforated plate 22 must be periodically removed. Removal of oxides adhering to the perforated plate is performed by raising and lowering the lever 26 in the direction of arrow X in Figure 3. Doing so makes one end of the perforated plate 22 move up and down by a large amount as shown by the dashed lines in Figure 3, so oxides adhering to the perforated plate 22 are scraped by molten solder and separate from the perforated plate 22 and float upwards. The oxides which float upwards in this manner are skimmed off with a ladle, a net, or the like and discarded in a waste vessel. When one end of the perforated plate is moved up and down in this oxide removal operation, the one end is moved up and down in the molten solder without projecting above the surface of the molten solder. This is because if the perforated plate projects above the surface of the molten solder, there is a danger of molten solder splashing when the perforated plate is lowered.

In a wave soldering bath according to the present invention, a perforated plate having a large number of holes with a diameter of 3 mm formed therein was installed 105 mm below the surface of molten solder in an oxide reservoir, and gutters were installed on both sides of discharge nozzles with a slope of 2°. A Sn-3Ag- 0.5Cu lead-free solder which is more susceptible to oxidation than a conventional Pb-Sn solder was introduced into the bath body, and soldering of printed circuit boards was carried out. During soldering, the lever mounted on the perforated plate was moved up and down every 4 hours to remove oxides adhering to the perforated plate. As a result, there were no printed circuit boards to which oxides adhered during soldering in a flow soldering bath according to the present invention. In contrast, when soldering was carried out in the same manner in a conventional wave soldering bath not equipped with gutters or a perforated plate, a large number of printed circuit boards having oxides adhered to the soldered surface were observed.

### Industrial Applicability

Conventional solders used in wave soldering baths were tin-lead alloys, but due to regulation for the use of lead, in recent years, lead-free solders having tin as a main component have come to be used. However, since lead-free solders have tin, which is easily oxidized, as a main component and their melting points are high, they have more occurrence of oxides than with conventional tin-lead alloys. A wave soldering bath according to the present invention has almost no discharge of oxides from discharge nozzles, and it provides particularly excellent effects when used with a lead-free solder.

## Claims

1. A wave soldering bath comprising a bath body having a discharge nozzle and a discharge pump installed therein, **characterized in that** an oxide reservoir is provided at one end of the bath body which is opposite from the end thereof where the discharge pump is installed, a gutter which is closed off at its end on the pump side is installed on the side surface of the discharge nozzle, a perforated plate is installed in the oxide reservoir so as to be submerged below the surface of the molten solder, one end of the perforated plate being pivotably mounted on the discharge nozzle or the bath body, and a lever which projects above the surface of the molten solder is installed on the other end of the perforated plate.

2. A wave soldering bath as set forth in claim 1 **characterized in that** the gutter slopes downwards towards the oxide reservoir.

3. A wave soldering bath as set forth in claim 1 **characterized in that** the perforated plate is installed 10 - 200 mm below the surface of the molten solder.

4. A wave soldering bath as set forth in claim 1 **characterized in that** the diameter of holes in the perforated plate is 2 - 10 mm.
